(19)

**Europäisches Patentamt**

**European Patent Office**

**Office européen des brevets**

(11) **EP 3 208 627 B1**

(12) **EUROPEAN PATENT SPECIFICATION**

(45) Date of publication and mention
of the grant of the patent:
**01.09.2021 Bulletin 2021/35**

(51) Int Cl.:
*G01R 33/12* *(2006.01)*  *G01R 33/09* *(2006.01)*

(21) Application number: **16305201.2**

(22) Date of filing: **19.02.2016**

(54) **MEASUREMENT SYSTEM AND METHOD FOR CHARACTERIZING AT LEAST ONE SINGLE MAGNETIC OBJECT**

MESSSYSTEM UND VERFAHREN ZUR CHARAKTERISIERUNG VON ZUMINDEST EINEM EINZIGEN MAGNETISCHEN OBJEKT

SYSTÈME DE MESURE ET PROCÉDÉ DE CARACTÉRISATION D'AU MOINS UN OBJET MAGNÉTIQUE UNIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**23.08.2017 Bulletin 2017/34**

(73) Proprietors:
 • **Université de Montpellier
 34090 Montpellier (FR)**
 • **Centre National de la Recherche Scientifique
 75016 Paris (FR)**
 • **AxLR, SATT du Languedoc Roussillon
 34090 Montpellier (FR)**
 • **Daegu Gyeongbuk Institute of Science
 and Technology
 Daegu 711-873 (KR)**

(72) Inventors:
 • **TERKI, Férial
 34270 Le Triadou (FR)**
 • **TRAN, Quang-Hung
 34090 MONTPELLIER (FR)**
 • **KAMARA, Souleymane
 34090 MONTPELLIER (FR)**
 • **FELIX, Gautier
 34090 MONTPELLIER (FR)**
 • **BOUSSEKOU, Azzedine
 31100 TOULOUSE (FR)**

 • **KIM, CheolGi
 704-843 Daegu (KR)**
 • **KIM, Kun-Woo
 Daegu (KR)**

(74) Representative: **Marks & Clerk France
Immeuble "Visium"
22, avenue Aristide Briand
94117 Arcueil Cedex (FR)**

(56) References cited:
 **EP-A1- 2 685 273**   **US-A1- 2002 135 358**
 **US-A1- 2011 175 605**   **US-B1- 7 046 002**

 • **SUNJONG OH ET AL: "Hybrid AMR/PHR ring sensor", SOLID STATE COMMUNICATIONS, PERGAMON, GB, vol. 151, no. 18, 29 May 2011 (2011-05-29) , pages 1248-1251, XP028251303, ISSN: 0038-1098, DOI: 10.1016/J.SSC.2011.05.049 [retrieved on 2011-06-12]**
 • **SUNJONG OH ET AL: "Analytes kinetics in lateral flow membrane analyzed by cTnI monitoring using magnetic method", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER BV, NL, vol. 160, no. 1, 19 August 2011 (2011-08-19), pages 747-752, XP028110965, ISSN: 0925-4005, DOI: 10.1016/J.SNB.2011.08.058 [retrieved on 2011-09-08]**

**Description**

TECHNICAL FIELD OF THE INVENTION

The present invention concerns a measurement system adapted to characterize at least one single magnetic object. The invention also relates to an associated measuring method.

BACKGROUND OF THE INVENTION

Nowadays nano-sized Spin CrossOver (SCO) particles receive more and more interests not only for the exploration of the physical properties of these materials at the mesoscopic scale, but also for the development of new functional materials. Up to now observations of the spin transition property was essentially reduced to the simple investigation of temperature dependence of the magnetization or the optical absorption in a huge ensemble of nano-particles with different degrees of size and shape dispersion. The development of methods for single Spin CrossOver (SCO) particle measurements is desirable for both fundamental and applicative perspective even if such efforts remain scare so far.

In the field of nano-scale magnetic measurements, the state of the art is represented by the micro-SQUID and nano-SQUID devices. These devices can detect the magnetization reversal of small amount of magnetic nano-particles or single molecule magnets by depositing directly the nano-particles on the micro-bridge Josephson junctions.

However, for low noise operation, the micro-bridges are normally made of low temperature superconducting materials such as niobium. Such devices are for example described in the article entitled "Magnetic Anisotropy of a Single Cobalt Nanocluster" from M. Jamet and al., published in the Physical Review Letters, Vol. 86, number 20.

Hitherto the working temperature of such a magnetometry detection system is limited below few tens of Kelvin.

Consequently, the conventional micro-SQUID technique is not appropriate to study the magnetization properties within the room temperature range, especially to carry out precise measurements of room temperatures switching properties of a small volume or a single nano-particle of a SCO material.

The current ultra-sensitive SQUID detection method suffers from several drawbacks as being used at very low temperature and requiring complex instruments that are not portable and not flexible.

SUMMARY OF THE INVENTION

The invention aims at avoiding such disadvantages and to provide an ultra-sensitive measurement system that performs measurements at room temperature, which is less complex and offers a more portable and flexible implementation.

In addition, another technical problem is to propose a measurement system and method that improves the sensitivity detection performance in order to detect nano or picotesla field generated by a "single micro/nano object" in the close vicinity of the sensor active surface.

To this end, the invention concerns a measurement system adapted to characterize at least one single magnetic object comprising a magnetic AMR/PHR sensor comprising an active surface on which at least one magnetic particle is deposited and including a magnetic probe with a closed loop shape, the magnetic probe being made in a structure chosen in the group consisting of a bi-layered structure including a ferromagnetic film and an anti-ferromagnetic film, a spin-valve structure including a ferromagnetic film, a metal, a ferromagnetic and an anti-ferromagnetic film, and a tri-layered structure including a ferromagnetic film, a metal and an anti-ferromagnetic film, a first terminal, a second terminal, both terminals facing each other and contacting with the magnetic probe, a source adapted to inject an alternative current or voltage in the magnetic probe, the source being connected between the first and second terminals and the current or voltage vibrating at an exciting frequency, and a voltage measurement device connected between the first and second terminals measuring the differential voltage between the pair of terminals, and a signal acquisition device adapted to extract the amplitude at twice the exciting frequency in the measured differential voltage and to deduce at least one physical quantity based on the extracted amplitude.

Thanks to this measurement system, the measurement system is easier to implement since no production of external magnetic field on the sensor is required.

This enables to obtain an accurate measurement system with improved sensitivity detection performance in order to detect nano or picotesla field generated by a "single micro/nano object" in the close vicinity of the sensor active surface.

According to further aspects of the invention which are advantageous but not compulsory, the measurement system might incorporate one or several of the following features, taken in any technically admissible combination:

- the measurement system is deprived of coils adapted to produce an external magnetic field on the sensor.

- the measurement system is deprived of preamplifier adapted to amplify the differential voltage.
- the magnetic probe has a ring shape.
- the magnetic probe has a multi-ring shape.
- the number of rings is comprised between 1 and 17.
- the signal acquisition device comprises a processor and a lock-in unit.
- the first terminal is a voltage terminal, the second terminal is a voltage terminal, the magnetic probe further comprising a first current/voltage terminal and a second current terminal/voltage, the first and second current/voltage terminals forming a pair of current/voltage terminals which face each other contacting with the magnetic probe, a first arm made of a first set of a predetermined ring number lower than 18 of circular meander paths delimited within a first quarter surface of the first magnetic sensor, the outermost meander path being connected to the first current/voltage terminal and the innermost meander path being connected to the first voltage terminal, a second arm made of a second set of the same predetermined number of circular meander paths delimited within a second quarter surface of the first magnetic sensor, the outermost meander path being connected to the second current/voltage terminal and the innermost meander path being connected to the first voltage terminal, a third arm made of a third set of the same ring number of circular meander paths delimited within a third quarter surface of the first magnetic sensor, the outermost meander path being connected to the second current/voltage terminal and the innermost meander path being connected to the second voltage terminal, and a fourth arm made of a fourth set of the same ring number of circular meander paths delimited within a fourth quarter surface of the first magnetic sensor, the outermost meander path being connected to the first current/voltage terminal and the innermost meander path being connected to the second voltage terminal.
- the physical quantity is relative to the at least one magnetic particle.
- the exciting frequency is at least 1 Hz.
- several magnetic particles forming a diamagnetic and paramagnetic mixture are deposited on the active surface and the physical quantity is the diamagnetic susceptibility of the mixture and the paramagnetic susceptibility of the mixture.

The invention also relates to a measuring method comprising the step of providing a measurement system adapted to detect the presence of at least one single magnetic object comprising a magnetic AMR/PHR sensor comprising an active surface on which at least one magnetic particle is deposited and including a magnetic probe with a closed loop shape, the magnetic probe being made in a structure chosen in the group consisting of a bi-layered structure including a ferromagnetic film and an anti-ferromagnetic films, a spin-valve structure including a ferromagnetic film, a metal, a ferromagnetic and an anti-ferromagnetic film, and a tri-layered structure including a ferromagnetic film, a metal and an anti-ferromagnetic film, a first terminal, a second terminal, both terminals facing each other and contacting with the magnetic probe, a step of injecting an alternative current or voltage in the magnetic probe, the current or voltage vibrating at the exciting frequency by using a source connected between the first and second terminals, a step of measuring the differential voltage between the pair of voltage terminals by using a voltage measurement device connected between the first and second terminals, a step of extracting the amplitude at twice the exciting frequency in the differential voltage by using a treatment signal device, and a step of deducing at least one physical quantity based on the extracted amplitude.

According to further aspects of the invention which are advantageous but not compulsory, the measurement system might incorporate one or several of the following features, taken in any technically admissible combination: several magnetic particles forming a mixture are deposited on the active surface and the step of deducing comprises the sub-steps of obtaining a total susceptibility of the mixture, extracting the diamagnetic susceptibility of the mixture, and obtaining the paramagnetic susceptibility of the mixture by using the total susceptibility of the mixture and the diamagnetic susceptibility of the mixture.

BRIEF DESCRIPTION OF THE DRAWINGS

The invention will be better understood on the basis of the following description which is given in correspondence with the annexed figures and as an illustrative example, without restricting the object of the invention. In the annexed figures:

- figure 1 shows schematically an example of measurement device comprising a magnetic AMR/PHR sensor, and
- figure 2 is a planar detailed view of the AMR/PHR multi-ring magnetic sensor of figure 1.

DETAILED DESCRIPTION OF SOME EMBODIMENTS

The present specification relies on research carried out by the applicant and on the following observations.
To overcome these drawbacks, micro-magnetometry devices have been addressed to probe spin transition at

3

room temperature in bistable materials (EP 2685273 A1). However, the conventional measurement technique limits sensitivity of the devices.

In a Planar Hall Effect micro-magnetometry device, the voltage responses to the signal of the particles as the following equation:

$$\mathrm{V}_{particle} = \mathrm{I} \cdot So \cdot \langle H_y \rangle$$

Where:

- $S_o$ is the field-sensitivity of the device,
- $H_y$ is the total average magnetic field acting on the device,
- $I$ is the bias current.

In general, the total average magnetic field $H_y$ could be due to the self-field from bias current or external magnetic field or from both of them.

$$\langle H_y \rangle = I\gamma\chi + \chi H_{app}$$

The first term is the magnetizing field of the particles due to the self-field from the sensor junction and the second term is the magnetizing field of magnetic particles from external magnetic field.

Possible measurement configurations could be:

(*i*) continuous bias current, continuous external magnetic field.
(*ii*) Continuous bias current, alternative magnetic field.
(*iii*) Continuous bias current, Mixture of continuous and alternative magnetic field.
(*iv*) Alternative bias current, alternative magnetic field.
(*v*) Alternative bias current, external magnetic field free.

In these measurement configurations, (*i*), (*ii*), (*iii*) and (*iv*) require an external magnetic field. Therefore, the device is more complicated. In addition, the noise external noise sources will result in the output voltage noise of the sensor.

Measurement configuration (*v*) is less complicated with no noise from external sources.

Therefore, in this invention, we utilize a high sensitivity measurement method based on magnetic field free technique to probe and analyze magnetic properties of at least one nanoparticles of bistable materials.

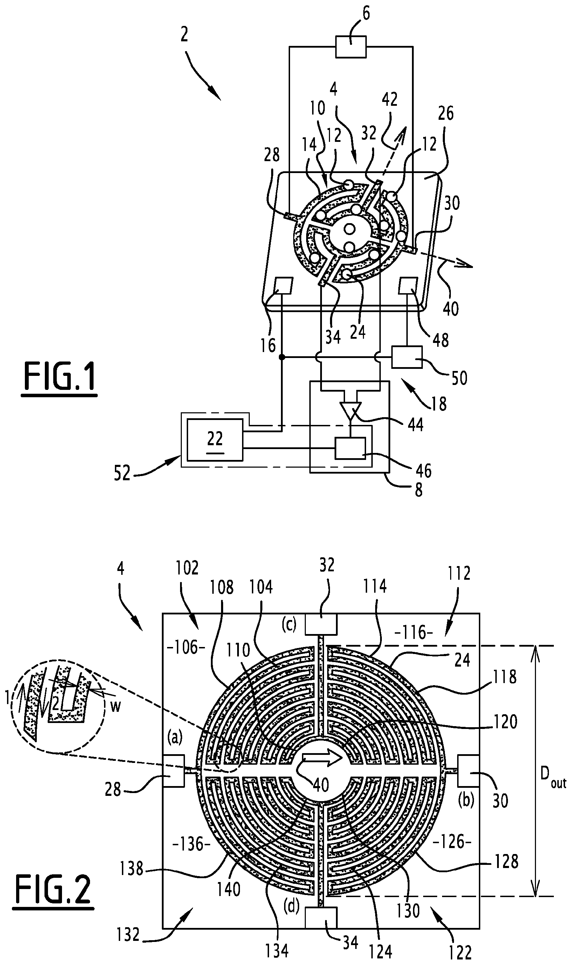

A measurement system 2 is illustrated on figure 1.

The measurement system 2 is adapted to characterize at least one single magnetic object.

In particular, the measurement system 2 is adapted to detect the presence of at least one single magnetic object.

The measurement system 2 is a micromagnetometry system.

As representative examples, the magnetic object can be cited: metallic materials, metallic oxides, rare earth elements, organometallic complexes, coordination complexes (magnetic molecules, magnet chains, and in particular spin cross-over materials, transfer of load materials.

The measurement system 2 comprises a magnetic AMR/PHR sensor 4, a source 6, a voltage measurement device 8, a first environmental temperature detector 16, a temperature controller 18 and a signal acquisition device 52.

The magnetic AMR/PHR sensor 4 is named sensor 4 in the remainder of the description.

The sensor 4 is a sensor adapted to detect AMR and PHR.

PHR is an acronym for Planar Hall Resistance.

The planar Hall resistance is based on the planar Hall effect of ferromagnetic materials. It measures the change in anisotropic magnetoresistance caused by an external magnetic field in the Hall geometry. The sensor responds to magnetic field components in the sensor plane as opposed to the ordinary Hall sensor, which measures field components perpendicular to the sensor plane. Hence the name "planar Hall". Generally speaking, for ferromagnetic materials, the resistance is larger when the current flows along the direction of magnetization than when it flows perpendicular to the magnetization vector. This creates an asymmetric electric field perpendicular to the current, which depends on the magnetization state of the sensor.

AMR is an acronym for anisotropic magnetoresistance.

Magnetoresistance is the property of a material to change the value of the electrical resistance of the material when an external magnetic field is applied to the material. More specifically, anisotropic magnetoresistance is a property of a material in which a dependence of electrical resistance on the angle between the direction of electric current and direction of magnetization is observed. The effect arises from the simultaneous action of magnetization and spin-orbit interaction and its detailed mechanism depends on the material. It can be for example due to a larger probability of s-d scattering of electrons in the direction of magnetization (which is controlled by the applied magnetic field). The net effect (in most materials) is that the electrical resistance has maximum value when the direction of current is parallel to the applied magnetic field.

The sensor 4 includes comprises an active surface 14.

On the active surface 14, a magnetic probe 24 with a closed loop shape is deposited on a substrate 26.

The magnetic probe 24 forms a magnetic track 24.

For instance, the magnetic probe 24 is made in a bi-layered structure including a ferromagnetic film and an anti-ferromagnetic film.

The sensor 4 further comprises a set 10 of at least one magnetic particles 12 deposited on an active surface 14 of the sensor 4.

Here, the magnetic particles 12 are $[Fe(hptrz)_3](OTs)_2$ Spin-Crossover nanoparticles elaborated in an homogenous solution of chloroform. The magnetic particles 12 are directly dropped on the whole active surface 14 of the sensor 4.

The magnetic particles 12 to be detected are thus motionless and placed close to or in contact with the active surface 14 of the sensor 4.

These magnetic SCO nanoparticles 12 exhibit a magnetic signature corresponding to the diamagnetic to paramagnetic transition wherein the transition temperatures or switching temperatures under open air with a predetermined degree of humidity are $T_{1/2\downarrow}$ equal to 325 K and $T_{1/2\uparrow}$ equal to 331 K while cooling and heating, respectively.

These transition temperatures have been verified by an optical reflectance change test that shows the same values under the same humidity conditions.

More generally, the magnetic particles 12 are assumed here to be molecular nanoparticles switchable in terms of a transition between two magnetic states when overstepping a predetermined temperature switching threshold, the temperature operating as a switching or actuating command.

The sensor 4 has a first current terminal 28 and a second current terminal 30 forming a pair of current terminals which face each other contacting with the closed loop magnetic track 24.

Alternatively, the sensor 4 has a first voltage terminal 28 and a second voltage terminal 30 forming a pair of voltage terminals which face each other contacting with the closed loop magnetic track 24.

As the same remarks apply to both kinds of terminals, in the remainder of the description, the first terminal 28 and a second terminal 30 are named first current terminal 28 and second current terminal 30 as only the specific example of figure 1 is described.

When referring to both embodiments, the expression "current/voltage terminal" is used.

The sensor 4 has a first current terminal 28 and a second current terminal 30 forming a pair of current terminals which face each other contacting with the closed loop magnetic track 24.

The sensor 4 has a first voltage terminal 32 and a second voltage terminal 34 forming a pair of voltage terminals which face each other contacting with the closed loop magnetic track 24 and from which an output differential voltage is detected.

The sensor 4 also has a first axis 40 or easy axis passing through the first and second current terminals 28, 30 being parallel to the exchange bias field direction of the material and perpendicular to a second axis 42 passing through the first and second voltage terminals 32, 34.

According to figure 2, the sensor 4 is based on a multi-ring architecture and is manufactured using a lithography technique in a clean-room of class 1000 with a lift-off process.

More specifically, the magnetic track 24 is a tri-layered material, for example Ta(3)/NiFe(20)/Cu(0.2)/IrMn(10)/Ta(3) (nm). In this structure, the soft magnetic layer NiFe is the sensing material that is weakly coupled to an anti-ferromagnetic layer (IrMn) by a long range exchange bias field through an atomic Cu sub layer.

The tri-layer structure Ta(3)/NiFe(20)/Cu(0.2)/IrMn(10)/Ta(3) nm is deposited by a 6 gun-magnetron sputtering system with a based vacuum of about $10^{-8}$ Torr.

To prevent the contamination and current leak, the magnetic sensor is passivated by a $Si_2O_3$ or $Si_3N_4/Si_2O_3$ bi-layer with a thickness of 200 nanometers.

The outer diameter of the sensor 4 is equal here to 300 $\mu$m and the width w of the magnetic track 24 is equal to 10 $\mu$m.

The magnetic track 24 of the sensor 4 has a first arm 102 made of a first set of a predetermined ring number m of circular meander paths 104 delimited within a first quarter surface 126 of the sensor 4, the outermost meander path 128 being connected to the first current terminal 30 and the innermost meander path 110 being connected to the first voltage terminal 32.

The ring number m is an integer comprised between 1 and 17.

The magnetic track 24 of the sensor 4 further comprises a second arm 112 made of a second set of the same predetermined number m of circular meander paths 114 delimited within a second quarter surface 116 of the sensor 4, the outermost meander path 118 being connected to the second current terminal 30 and the innermost meander path 120 being connected to the first voltage terminal 32.

The magnetic track 24 of the sensor 4 also comprises a third arm 122 made of a third set of the same ring number m of circular meander paths 124 delimited within a third quarter surface 126 of the sensor 4, the outermost meander path 128 being connected to the second current terminal 30 and the innermost meander path 130 being connected to the second voltage terminal 34.

The magnetic track 24 of the sensor 4 further comprises a fourth arm made 132 of a fourth set of the same ring number m of circular meander paths 134 delimited within a fourth quarter surface 136 of the magnetic sensor 4, the outermost meander path 138 being connected to the first current terminal 30 and the innermost meander path 140 being connected to the second voltage terminal 34.

This multi-ring architecture enhances the sensitivity of the sensor 4 in a compact region.

As the length of the arms increases with the ring number, filling the sensing meander paths enhances the active sensing area.

The current direction alternately changes for successive ring paths, i.e. there is a current angle range $\theta = \pi / 2$ to 0 for path 1 shown in the inset of Figure 2, and $\theta = \pi$ to $3\pi/2$ for path 2 in the inset of Figure 2. The sign of the calculated value for path 1 and 2 is the same, which means that AMR effect for both currents is additive. Thus, the maximum voltage variation in the profiles and accordingly the field sensitivity of the arm resistance increases the ring number.

The voltage profile for the full magnetic ring is a linear response across zero field, where the AMR/PHR voltage of the ring are additive for all junction components

The sensitivity of first magnetic sensor is enhanced by using a tri-layer structure which has a small exchange coupling field and high active current.

This multi-ring architecture enhances the field sensitivity and the active area of the sensor 4.

Thus, the sensor 4 is a highly sensitive magneto-resistive (MR) sensor based on Planar Hall Effect (PHE) that is capable to detect the switching of the spin states of SCO nano-particles.

Preferably, the ring number m of circular meander paths is comprised between 9 and 17. Here, each arm has eleven meander paths or quarters of circular rings, this number maximizing the sensitivity of the sensor 4.

This multilayer stack exhibits a very high sensitivity of about $S = 6$ V.T$^{-1}$ and a low white noise of about 1 nV·Hz$^{-1/2}$ at 100 Hz.

The source 6 is adapted to inject an alternative current in the magnetic probe 24.

The source 6 is connected between the first and second current terminals 28, 30.

The source 6 is adapted to inject an alternative current vibrating at an exciting frequency.

The exciting frequency is comprised between 5 Hz (Hertz) and 10 kHz (kilohertz).

The source 6 is for example a Keithley 6221 AC Current source or Agilent 33522A voltage source, the amplitude of the AC bias current is set equal to 1 mA$_{rms}$. the expression "rms" stands for "root means square".

The voltage measurement device 8 is adapted to measure the differential voltage between two points.

In the example of figure 1, the voltage measurement device 8 is connected between the first voltage terminal 32 and the second voltage terminal 34.

The voltage measurement device 8 is adapted to measure the differential voltage between the pair of voltage terminals.

The environmental temperature sensor 16 is configured to measure a temperature representative of the actual environmental temperature T of the magnetic particles 12 and the sensor 4, and is preferably located close to the active surface 14 of the sensor 4. For instance, the environmental temperature sensor 16 is a platinum resistance of 100 Ohms.

The temperature controller 18 is adapted to control and/or to regulate the environmental temperature of the magnetic particles 12. More specifically, the temperature controller is configured to heat by a heater 48 in a controlled way the environment of the magnetic particles 12 and are preferably located close to the active surface 14 of the sensor 4.

The heater 48 is for instance a peltier heat sink element attached to the first magnetic sensor 4 and connected to a temperature controller 50 that controls the environmental temperature T variation by varying the temperature T from 77 K to 690 K.

The signal acquisition device 52 is adapted to extract the amplitude at twice the exciting frequency in the measured differential voltage.

The signal acquisition device 52 is further adapted to deduce at least one physical quantity based on the extracted amplitude.

The physical quantity is relative to the at least a single magnetic particle 12.

As the measurement system 2 can be used to detect a magnetization variation (magnetization commutation) of all magnetic materials (paramagnetic, diamagnetic, ferromagnetic, antiferromagnetic, ferrimagnetic) in different forms (materials in the form of microcristalline powders, nanoparticles, thin layer) and at any temperature, the physical property is linked to the magnetic behavior of magnetic nanoparticles.

As the measurement system 2 can be used to characterize and to quantify the magnetic phase, magnetic transition of all magnetic materials (paramagnetic, diamagnetic, ferromagnetic, antiferromagnetic, ferrimagnetic) in different forms (materials in the form of microcristalline powders, nanoparticles, thin layer and thin multilayers) and at any temperature, the physical property is linked to the magnetic behavior of magnetic nanoparticles.

Notably, the physical property is the paramagnetic or mixture of paramagnetic and diamagnetic or diamagnetic susceptibility.

As illustrated in figure 1, the signal acquisition device 52 comprises a lock-in unit 46 and a processor 22.

The lock-in unit 46 is adapted to extract the amplitude at twice the exciting frequency in the measured differential voltage.

The processor 22 is adapted to treat the amplitude extracted by the lock-in unit 46 to deduce at least one physical quantity based on the extracted amplitude.

Notably, the processor 22 is configured for detecting from a set of different differential voltages measured by the voltage measurement device 8 a magnetic flux change representative of the presence of at least one deposited magnetic particle 12 on the active surface 14 of the sensor 4.

The processor 22 is configured to, after the deposit of an unknown amount of magnetic particles 12 upon the first magnetic sensor 22 and after varying the temperature T over the predetermined temperature range, determine a first curve of the evolution versus temperature of the differential voltage measurements outputted by the voltage measurement device 8 and carried out under the known environmental physical conditions and operating system settings.

The processor 22 is configured to subsequently determine over the predetermined range of temperature a second curve as a fitting curve from a lower portion of the first curve, this lower portion of the first curve corresponding to a lower interval included within the predetermined range of temperature, the lower interval having its upper bound lower than the temperature switching threshold.

The processor 22 is configured to, subsequently determine a third curve as the difference versus the temperature of the differential voltages of the first curve and the differential voltages of the second curve within the same range temperatures, namely [300K, 400K].

The processor 22 is configured to subsequently detect the presence of at least one magnetic particle 12 when the third curve exhibits a temperature interval wherein a voltage transition occurs and when the amplitude of this transition is greater than a predetermined detection threshold, the predetermined detection threshold corresponding to a minimal magnetization field change detectable of 100 pT.

Operation of the measurement system 2 is now described in reference to an example of carrying out a measuring method.

The measuring method comprises the step of providing, a step of injecting, a step of measuring, a step of extracting and a step of deducing.

At the step of providing, a measurement system 2 as described in reference to figures 1 and 2 is provided.

At the step of injecting, an alternative current is injected in the magnetic probe 24.

The alternative current or voltage vibrates at the exciting frequency by using a source connected between the first and second current terminals.

As will appear in the experimental section, it can be shown that the alternative current generates a differential voltage between the pair of voltage terminals vibrating at twice the exciting frequency.

At the step of measuring, the differential voltage between the pair of voltage terminals is measured by using the voltage measurement device 8.

At the step of extracting, the component at twice the exciting frequency is extracted in amplitude in the measured differential voltage.

To carry out the step of extracting, the signal acquisition device 52 is used.

According to the example of figure 1, the lock-in-unit 46 is used.

At the step of deducing, at least one physical quantity is obtained based on the extracted amplitude.

To carry out the step of deducing, the processor 22 is used.

The measurement system 2 thus enables to characterize the magnetic behavior of magnetic nanoparticles 12 without external applied magnetic field. Such characterization is achieved by using the self magnetic field generated by the sensor 4.

The experimental set-up for the measurement system 2 is thus easier to implement.

Furthermore, such set-up minimizes the noises from external noise sources and thus enables to increase the sensitivity.

Many other embodiments may be considered for the measurement system 2.

Alternatively, the magnetic probe 24 is made in a bilayer structure, tri-layer or a spin-valve structure.

According to another embodiment, the magnetic probe 24 is made in a tri-layered structure including a ferromagnetic film, a metal and an anti-ferromagnetic film.

According to a preferred embodiment, the measurement system 2 is deprived of coils adapted to produce an external magnetic field on the sensor 4.

Optionally or in combination, the measurement system 2 is also deprived of amplifier adapted to amplify the differential voltage.

Such amplifier may be qualified in this context as a "pre-amplifier".

In a variant of the measurement system 2, the sensor 4 comprises two AMR/PHR multi-ring magnetic sensors.

For instance, the first and second AMR/PHR multi-ring magnetic sensors have a same magnetic structure and a same shape amongst a cross shape or a single ring closed loop shape.

The first and the second magnetic sensors with a same shape amongst a cross shape or a single ring closed loop shape are placed so that their respective easy axis, are collinear in terms of direction i.e are parallel between each other.

According to another embodiment, the magnetic probe 24 has a ring shape.

The method described is applicable to any for magnetic particles 12 that are switchable molecular nanoparticles by overstepping a predetermined switching threshold in terms of a switching physical property that operates as a switching command. Such magnetic particles are any switchable molecular nanoparticles in form of $A_h B_k[M(CN)_6]_l.mH_2O$, where A can be Co, Ni, Fe, etc, B and M can be various transition metals ($Fe^{II}$, $Fe^{III}$, $Mn^{II}$, $Mn^{III}$, fml a$Co^{II}$, $Co^{III}$, ...) and C is an alkali metal

Such measurement system 2 is appropriate for specific use.

For instance, as further detailed in the experimental section, several magnetic particles 12 forming a mixture is deposited on the active surface 14 and the physical quantity is the diamagnetic susceptibility or diamagnetic and paramagnetic susceptibility of the mixture.

In such circumstances, the step of deducing comprises the sub-steps of obtaining a total susceptibility of the mixture, extracting the diamagnetic susceptibility of the mixture, and obtaining the paramagnetic susceptibility of the mixture by using the total susceptibility of the mixture and the diamagnetic susceptibility of the mixture.

Such measurement system 12 is the first measurement system adapted to separate diamagnetic and paramagnetic phases and to obtain the paramagnetic susceptibility of the small quantities of mixture with a good accuracy.

The embodiments and alternative embodiments considered here-above can be combined to generate further embodiments of the invention.

EXPERIMENTAL SECTION

*Characterization of the self magnetic field at a AMR/PHR sensor active surface 14* : *Towards the detection of the single objects*

In this section, it is proposed to work out the magnetic field generated by the sensor 4 using the well known Biot and Savart law. Furthermore, this theoretical approach is supported by an original experimental detection of the self magnetic field induced by the magnetic AMR/PHR sensor 4.

The Applicant has developed an original experimental set-up, which allows to quantify the self magnetic field (SMF) value of a AMR/PHR sensor 4. The technique consists to take two different sensors 4, aligned them and put their active surface 14 in contact. The first is a transmitter. The input current is in alternative mode (AC), with the aim of generating an alternative magnetic field. The second is located above the transmitter, and is used as a detector with a direct current (DC) input. The terminal voltage on the detector has two components, direct and alternative due to the presence of direct magnetic fields and the alternative magnetic field generated by the transmitter, respectively. The DC and AC voltages can be decorrelated, allowing to measure only the magnetic field produces by the transmitter. The transmitter and the detector are placed in a milliradian goniometer support and nanometer displacement support, respectively.

For low homogeneous magnetic field intensity along all the sensor 4, the AMR/PHR voltage U is linearly dependant with the input current I and the magnetic external magnetic field H:

$$U = S.I.H \text{ (Equation E1)}$$

Where:

- S is the sensitivity of the sensor 4, and
- I is the active current passing through sensing layer of the thin film.

The sensitivity S depends on the radius and the width of the ring, and on the number of rings.

It is important to note, the sensor 4 is sensitive to only one component of the external magnetic field. The component is in the same plane, but perpendicular, to the easy axis 40.

To understand the measured terminal voltage, the SMF cartography of the sensor 4 is simulated in parallel. The Biot and Savart law allows to calculate the magnetic field produces by the propagation of a current density in a defined volume. The law is defined as follows:

$$\overrightarrow{B(M)} = \iiint_V \frac{\mu_0}{4\pi} j x \frac{\overrightarrow{PM}}{PM^3} dV \text{ (Equation E2)}$$

Where:

- P is a point in the sensor volume V,
- M is the studied point in the sensor volume V, and
- $j_x$ is the current vector in x direction.

To avoid the problem of singularities in the equation E2 (when P=M), the well-known Monte Carlo (MC) integration technique is used. To calculate the magnetic field in a point the Monte Carlo process is:

(i) a point is chosen randomly with a uniform distribution in the volume ;
(ii) if the singularity is chosen another point is selected randomly;
(iii) the function f which has to be integrated in the volume V is calculated at the point P ($f_P$);
(iv) the three previous sequences are repeated times;
(v) an estimation of the integral is calculated by using the following formula:

$$I(M) = \lim_{N \to \infty} \frac{V}{N} \sum_{P-1}^N f_P$$

The calculation reveals that the intensity of the field is very high near the ring, and decreases dramatically with the distance. There is also a significant variation for the different vector components of the field, which means a local behavior of the SMF.

The behavior of the AMR/PHR sensor 4 is well defined for the detection of a homogeneous magnetic field. In such case, the detection of the local field is approximated as the detection of a homogeneous magnetic field (see equation E1). The intensity of this homogeneous field is equal to the average of the local field on the detector volume $V_d$.

$$\langle \vec{B} \rangle_{V_d} = \frac{1}{V_d} \iiint_{V_d} \iiint_{V_t} \frac{\mu_0}{4\pi} j x \frac{\overrightarrow{PM}}{PM^3} dV_t \, dV_d \text{ (equation E3)}$$

Where M belongs to the detector volume $V_d$ while P belongs to the total volume of the transmitter sensor $V_t$.

It is important to note that the AMR/PHR sensor 4 is sensitive only along one axis of the sensor plane, which is perpendicular to the easy magnetic axes. For the next, only this axis 42 is considered and labeled y. The magnetic field along y axis is written as follows:

$$\langle \overrightarrow{B_y} \rangle_{V_d} = -\frac{1}{V_d} \iiint_{V_d} \iiint_{V_t} \frac{\mu_0}{4\pi} \frac{j_x z_{PM}}{PM^3} dV_t \, dV_d \text{ (equation E4)}$$

Where:

- $j_x$ is the x component of the current vector,
- $z_{PM}$ is the z component of the vector $\overrightarrow{PM}$.

This 6 dimensional integral can be calculated using the MC integration technique presented previously. The point (i) is modified as follows: (i) two points P and M are chosen randomly with a uniform distribution in the volume $V_t$ and $V_d$, respectively.

If a uniform current density is considered, the intensity of the current density $\|\overline{j}\|$, inside a ring conductor, can be written as follows:

$$\|\vec{j}\| = \frac{I}{2\omega t} \text{ (equation E5)}$$

Where:

- I is the input current intensity
- $\omega$ is the width of the ring conductors, and
- t is the thickness of the ring conductors,

Then, the x component of the current density can be written as follows:

$$j_x = \vec{j}.\hat{e}_x = \|\vec{j}\|\hat{j}.\hat{e}_x \text{ (equation E6)}$$

Where:

- $\hat{j}$ is the current density unit vector,
- $\hat{e}_x$ is the x-axis unit vector.

Using the equations 5 and 6, the equation 4 becomes:

$$\langle\vec{B_y}\rangle_{V_d} = -\frac{I}{2V_d\omega t}\iiint_{V_d}\iiint_{V_t}\frac{\mu_0}{4\pi}\frac{\hat{j}.\hat{e}_x z_{PM}}{PM^3}\,dV_t\,dV_d \text{ (equation E7)}$$

Notably, the field value calculating from 6D integral of the equation E7 depends on the architecture of the transmitter and the detector (number of rings). Then, for identical architectures of the transmitter and the detector, and for an identical distance between the two elements, the equation E7 can be simplified as the following form:

$$\langle\vec{B_y}\rangle_{V_d} = \alpha.I \text{ (equation E8)}$$

An experimental set-up, including one non-passivated ring as transmitter and one passivated ring as detector, was developed to quantify the magnetic self-field of the sensor 4 and to justify the theoretical calculations. In the first step, the current intensities are kept at constants, and only the distance z between the transmitter and the detector is varied. In this measurement, the experiment is well fitted with calculation while taking into account the misalignment of x = 21 $\mu$m and of y = 45 $\mu$m.

The second experiments were done with a fix distance from transmitter and detector while changing the input current of the transmitter. This experiment helps to go deeper in the understanding of the sensor 4 behavior in a local field. For the distances between the detector and the transmitter of 0 $\mu$m, 300 $\mu$m and 600 $\mu$m, the evolution of the detected magnetic field (by the detector) is linearly response as a function of the input current (in the transmitter). Such linear behavior confirms the theoretical prediction of equation 8, and consolidates the idea of an average of the local field detected by the sensor 4.

This combined experimental-theoretical approach leads to two major conclusions. The first is the magnetic sensor 4 behavior submitted to a local field is the same as the magnetic sensor 4 behavior submitted to a homogeneous magnetic field. The magnetic field value returned by the sensor 4 is the average of the local magnetic field over the detector volume. The second is the calculations of the local magnetic field can be used in further simulations, modelling the interaction between a magnetic sample and the SMF.

*Optimization of the Spin-CrossOver signals detection using AMR/PHR multi-ring sensor 4 and self-induced field in the sensor 4*

The Applicant reports in this section the optimization of the spin transition detection in the bistable Spin-Cross-Over (SCO) materials using AMR/PHR multi-ring sensor 4 and self-field of the sensor 4. The in-phase ($\chi'$) and out-of-phase ($\chi''$) ac susceptibility components are recorded by the second harmonic voltage response without any pre-amplifier. Systematic qualitative and quantitative studies are performed. The Applicant has shown that the diamagnetic-to-paramagnetic spin transition of a few volume of about $1 \times 10^{-4}$ mm$^3$ can be detected using the ultra-sensitive 11-rings sensor 4 and the low bias current of 120μA. The local measurements of the Applicant's system allowed us to reach the ultra-high resolution of $3 \times 10^{-13}$ emu at room temperature. Combining the experimental data and the beads-sensor dipolar field theory the Applicant has estimated the number of the detected magnetic particles 12 by the sensor 4 and shown that this increases with the bias current, i.e self-field. The calculation shows that the limit of detection (LOD) of the sensor 4 in terms of magnetic moment is as low as $4 \times 10^{-14}$ emu. In parallel, the magnetic studies were investigated and reveal the presence of the small diamagnetic signal even in paramagnetic phase. The Applicant has successfully to separate the diamagnetic to the paramagnetic phase in the SCO materials. The extracted paramagnetic susceptibility is slightly superior to the value measured by a high sensitivity SQUID measurements (LOD is about $10^{-10}$ emu) on bulk materials. It is to be noted that the sensitivity of the sensor 4 is higher than a SQUID system, at least 4 orders of magnitude. Thus, the sensor can separate diamagnetic phase from total susceptibility, whereas the SQUIDs could NOT achieve such separation.

*Introduction*

Currently, the nanoscale spin-crossover materials (SCO) having, at a given temperature, a bistability between low- and high-spin states are the subject of great interest. The phenomenon is prevalent in iron chemistry and corresponds to the distributions of electrons within the metal orbital energy levels. The spin transition in SCO has large impact on its physical properties such as magnetic moment, color change, dielectric constant and electrical resistance. Display and memory devices, electroluminescence device, guest molecule sensing and electromechanical actuating device are some practical applications of SCO that make use of their switching properties.

Due to their low magnetic signal, several studies on spin switching of SCO material have been reported in large amount of nanoparticles: powder, crystal or bulk. Specially the spin transition detection by temperature dependence of molar susceptibility (using optical reflectance and SQUID measurements respectively. These methods are inadequate either for very few quantities and single nanoparticles investigation or for applications. It is therefore essential to develop the news instrumental measurement methods to follow the SCO transition at nano-scale.

Recently, the Applicant has reported a novel prototype for a SQUID-like magnetometry device for detection of room temperature switching in an SCO nanoparticles. Combining the high sensitive MR sensor 4 and the original AC and DC magnetic field components for measurement, the Applicant has observed for the first time via electrical measurement, the thermal hysteresis of spin-transition of small quantity of SCO material. However, this measurement method is sensitive to the applied magnetic field direction and is optimal for the magnetizing angle $\alpha = 20°$.

In the detection of magnetic beads using the self-generated magnetic field, it has been shown that the AMR/PHR cross-junction sensor were capable to detect the presence of 2 μm micromer-M beads on the vicinity of the active surface 14 without applying magnetic field. Later first observation of the beads being magnetized by the self-field using second harmonic measurement has been reported. Nevertheless, all these previous works are focused on commercial magnetic labels detection using microfluidic and lab-on-chip systems for biosensors applications. Furthermore the magnetic susceptibility of these magnetic labels is a ten thousand times higher than SCO nanoparticles. Usually, the bias-current of 10 - 30 mA are used to generate sensor self-field in bilayers cross or bridge sensors. In this case the local temperature can increases up to 5° and can distort the measurements. Hence, the necessity to apply low bias current is strongly desired.

In this section, the optimization of spin switching detection in SCO materials by AC susceptibility measurement using multi-ring sensor self-field, low-bias current and second harmonic technique is detailed.

*Theory*

In the planar Hall effect geometry and low magnetic field range, the AMR/PHR sensor voltage can be written as the equation E11:

$$V_{out} = I.\left[So.\langle H_y \rangle + R_{offset}\right] \text{ (equation E11)}$$

Where:

- So (V.m/A$^2$) is the sensitivity,
- $\langle H_y \rangle$ is the total average magnetic field acting on the sensor 4 in the y-direction,
- I is the bias current and
- $R_{offset}$ is an offset of sensor 4.

Without the external magnetic field, the effective self-field acting on the sensor 4 due to the bias current is expressed as a sum of two contributions:

$$\langle H_y \rangle = \gamma_0.I + \gamma_1 \chi.I \text{ (equation E12)}$$

The first term is due to the applied current to sensor 4, whereas the second is from the beads being magnetized by the sensor self-field, $\chi$ is the magnetic beads susceptibility and $\gamma_0, \gamma_1$ are the constant depending on the distribution and geometry of the sensor 4.

Combining the above expression and equation E12, the output voltage become proportional to $I^2$. When the AC bias-current with frequency f is applied, the signal is more sensitive and can be detected at double frequency 2f.

Measurement in the frequency domain are characterized by the complex magnetic susceptibility $\chi = \chi' - i\chi''$ where i is the complex number.

The lock-in technique allows to measure the second harmonic voltage $V_2 = X_2 + iY_2$. The second harmonic in-phase, $X_2$, and the out-of-phase, $Y_2$, signals are proportional to the out-of-phase $\chi''$ and the in-phase $\chi'$ susceptibility, respectively. This can be summarized as follows:

$$X_2 \propto I_0^2.So.\gamma_1\chi''$$
$$Y_2 \propto I_0^2.So.\left(\gamma_0 + \gamma_1\chi'\right) \text{ (equations E13)}$$

These equations show that it is possible to measure separately the in- and out-of-phase AC susceptibility components of SCO nanoparticles.

*Experimental*

In this study, the highly sensitive AMR/PHR 11-rings sensor 4 was used to detect the spin-transition in [Fe(hptrz)$_3$](OTs)$_2$ SCO nanoparticles. The architecture of the sensor 4 is based on trilayer structure Ta(3)/NiFe(10)/Cu(0.1)/IrMn(10)/Ta(3) (nm). The sensing layer is the soft magnetic layer NiFe, which is weakly exchange-coupled to an antiferromagnic layer IrMn through an atomic sub-layer of Cu. The ring architecture also presents very high signal-to-noise ratio and small offset voltage by self-balanced due to its Wheatstone bridge configuration.

As in previous works, the Applicant had selected the SCO Fe-triazole derivative compound [Fe(hptrz)$_3$](OTs)$_2$ (where hptrz=4-heptyl-1,2,4-triazole and OTs=p-toluenesulfonyl) due to its appealing spin transition properties (large hysteresis loop within the room temperature). This compound is composed by 1D chains constituted by Fe(II) ions bridged by three heptyltriazole molecules. The tosylate anions and water molecules are situated between the chains, which are packed within the 3D supramolecular structure. These SCO nanoparticles were characterized by transmission electron microscopy (TEM) revealing regular-shaped nanocrystals with a mean size of 114 $\pm$ 19 nm. The SCO properties were studied by optical reflectivity confirming an abrupt spin transition (T1/2 $\downarrow$= 305 K and T1/2$\uparrow$= 324 K for the first cycle; T1/2 $\downarrow$= 307 K and T1/2$\uparrow$= 326 K for the second cycle) with a hysteresis width of 19 K.

The sensor 4 in this experiment has radii of 150 $\mu$m and the magnetic sensitivity of 6 V/T at low magnetic field range. The alternative currents with amplitude range of 0 to 1 mA were applied to generate a low self-field acting on the active surface 14. This ensures that only the nanoparticles very close to the active surface 14 will be magnetized. The signal of the sensor 4 is measured by a high sensitive digital lock-in amplifier RS830 with the second harmonic detection. A few volume of the ethanol suspension of Fe-(hptrz)$_3$(OTs)$_2$ nanoparticles is directly dropped onto the active surface 14.

The sensor 4 is placed in a close chamber of the LinKAM heating-cooling controller system for temperature setup and also to avoid the gas environment contamination. Before measurements, the sensor 4 with nanoparticles are heated at high temperature to eliminate all liquid solution then immersed in a dry nitrogen atmosphere. All measurements are carried out without external magnetic field, electric or magnetic shielding and without any preamplifier.

*Results and discussions*

Output voltage of the sensor 4 (second harmonic in-phase, $X_2$, and out-of-phase, $Y_2$) were measured with respect to the temperature for two cases of without and with SCO nanoparticles on the active surface 14. When differentiate these two curves, a large temperature hysteresis of voltage is clearly observed. This hysteresis voltage is the result of spin-transition of SCO nanoparticles.

Theoretically, when magnetizing the SCO nanoparticles with an AC self-field $H_{sf}(t)$ created by the sensor 4, magnetization of SCO nanoparticles will be: $\chi_{ac}(\omega,T)\langle H_{sf}(t)\rangle$. This expression is equivalent to:

$$\chi_{ac}(\omega,T) = \chi'_{ac}(\omega,T) - i\chi''_{ac}(\omega,T),$$ with $\chi'_{ac}(\omega,t)$ $\chi''_{ac}(\omega,t)$ are in-phase and out-of-phase susceptibilities. These susceptibilities are temperature dependence, thus in-phase and out-of-phase voltages ($X_2$ and $Y_2$) in equation E13 are very sensitive to the thermodynamic phase changes. Indeed, sensor 4 detects the magnetic signature of the diamagnetic-to-paramagnetic phase transition in the bistable SCO materials.

When representing the temperature dependence of the out-of-phase voltage $Y_2$ for several bias current i.e self-field (similar behavior was observed on the in-plane voltage $X_2$ component), the spin transition is not observed for the current amplitude of 30 µA and bellow. Beyond the current ($I_c \approx 95$ µA), the spin-transition is observed in all measurements without subtracting the voltage of the sensor 4 backline. Moreover, the magnitude of the hysteresis ($\Delta V$) increase with the current amplitude. From these measurements we can remark two points. The first point is that there is a critical current, $I_c$, at which the magnetized SCO could be detected by the sensor 4. The second point is that the number of the detection volume of SCO nanoparticles 12 is increase with the bias-current.

For quantitative analysis, the Applicant focused on the voltage response $V_{stray}$ caused by the stray field (demagnetizing field) generated exclusively by nanoparticles.

For this, reference temperature signal of sensor 4 before dropped nanoparticles was performed for each bias current and the voltage drift is subtracted to the total voltage response with SCO.

$$V_{total}(T) = V_{stray}(T) + V_{drift}(T) \text{ (equation E14)}$$

The voltage response of 0,2µl droplets (c = 0.66µg/µl) after subtracting the voltage drift of the device can then be drawn. It is noteworthy that magnetic signal for this quantity cannot be detected by a conventional high sensitive SQUID device.

$V_{stray}(T)$ curve shows the quasi abrupt spin-transition at the temperatures of cooling and heating cycles of T1/2↓= 302 K and T1/2↑= 321 K respectively. The switching temperatures and the hysteresis width of 19 K observed here are in good agreement with the optical reflectance measurements. The $V_{stray}$ induced by this nanoparticles quantity is 0.16 µV (noise value of 20 nV).

In the following, we evaluate roughly the number of the nanoparticles detected in this experiment. In high spin state the stray field produced by N nanoparticles being magnetized by self-field of sensor 4 is $\langle H_{stray} \rangle = N.\ \gamma_1 \chi.I$. The stray voltage can be written as:

$$V_{stray} = I.So.\langle H_{stray} \rangle = N.I^2.So.\gamma_1 \chi \text{ (equation E15)}$$

Here $\gamma_1$ is a constant depending on the geometry, size and the self-field strength of sensor 4, the size of the measured particle 12 and the distance from sensor 4 to the particle 12. $\gamma_1$ is given by:

$$\gamma_1 = -\frac{R^3.H_{sf}}{3.z_0^3.I.\left(1+\frac{r_s^2}{z_0^2}\right)^{\frac{3}{2}}} \text{ (equation E16)}$$

Where:

- R is the mean radius of the SCO nanoparticle;
- $H_{sf}$ is the self-field of the sensor 4 ;
- $r_s$ is the radius of the element of the sensor 4 and
- $z_0$ is the distance from the nanoparticle to the sensor 4.

The negative sign means that the stray field reduces the voltage of the sensor 4.

Here, the self-field $H_{Sf}$ (A/m$^2$) created by the bias-current circulation in the microcoil-like sensor 4 magnetize the nanoparticles. Likewise the active radius of the element of the sensor 4 can write as:

$$r_s^2 = r_{ext}^2 - r_{int}^2$$

Where

- $r_{ext}$ is the external radius of the element of the sensor 4, and
- $r_{int}$ is the internal radius of the element of the sensor 4.

In the above measurement, a current I = 120 $\mu$A was applied, the average self-field of the sensor 4 is calculated to be $\langle H_{sf} \rangle$ = 20 $\mu T$ (by the Bio Savart law and characterized by sensor-transmitter/sensor-detector measurements technique).

The magnetic susceptibility of nanoparticles was $\chi$ = 4,2.10$^{-4}$ (calculated from the SQUID measurements). With a voltage change of 0.16 $\mu$V, the stray field, the number and the volume of detected nanoparticles is calculated (from equation E15) to be $\langle H_{stray} \rangle$ = 26.7$nT$, N $\approx$ 7. 10$^7$ and 1.2$\times$10$^{-4}$ mm$^3$, respectively. Thus, the total magnetic moment of this ultra-small volume of nanoparticles can be calculated to be ca. m $\approx$ 3. 10$^{-13}$ emu. The Applicant has reached here the highest magnetic moment resolution at room temperature. For reference, a conventional high resolution SQUID system has a resolution of 10$^{-10}$ emu only.

Utilizing this high resolution device, the Applicant investigated the magnetic properties of nanoparticles in order to determine the low paramagnetic susceptibility of nanoparticles by the electrical way. For that the current dependence of the in-phase ($\chi$') and out-of-phase ($\chi$") components of the AC susceptibility was performed. To extract the magnetic signal of nanoparticles, the Applicant carried out the second harmonic in-phase $X_2$ and out-of-phase $Y_2$ sensor voltage measurement versus bias current without and with nanoparticles. Then the nanoparticles signals were extracted by simply subtraction. The measurements were carried out at Low Spin state, T = 290 K (diamagnetic phase) and at High Spin state, T= 345 K (paramagnetic phase).

In High Spin state (paramagnetic phase) the nanoparticles signal reveals a small negative voltage response between 100 $\mu$A and 600 $\mu$A. This can be attributed to the presence of diamagnetic phase which remains even at HS. It is known that the diamagnetism exists in all compounds and it is independent to the temperature and magnetic field. It is normally negligible in the high magnetic susceptibility compounds. But it is considerable in a small quantity of low susceptibility compounds as the nanoparticles investigated in this invention. In fact, the conventional methods used to measure the magnetic susceptibility cannot separate the diamagnetic phase to the paramagnetic phase. Because in such measurements, the diamagnetic susceptibility, $\chi_{dia}$ is negative and much smaller than the paramagnetic susceptibility, $\chi_{para}$. In the Applicant's experiment, the diamagnetic phase has been successfully separated from the paramagnetic phase. The paramagnetic susceptibility is obtained by subtracting the negative diamagnetic susceptibility from the total magnetic signal $\chi_{para} = \chi_{total} - \chi_{dia}$.

After correction of the paramagnetic susceptibility, the measured voltage of the sensor 4 for the spin-transition of nanoparticles is proportional to the current squared (agreement with equation E13). The best fitting experimental data gives the magnitude of the susceptibility $\chi_{para}$ = (5,6 $\pm$ 0,3).10$^{-4}$ (SI). This characterized $\chi$ value is slightly superior to the susceptibility measured by a SQUID system for the bulk SCO material ($\chi$ =4,2.10$^{-4}$). Finally, fitting data from equations E13 provides the critical current value, Ic = 95 $\mu$A for the detection of identical amount of SCO nanoparticles (1.2$\times$10$^{-4}$ mm$^3$). The detection limit of the sensor 4 is therefore could be deduced to be 4$\times$10$^{-14}$ emu.

*Conclusion*

In summary, the Applicant has optimized the method of following the spin-transition switching using self-field of the sensor 4. The Applicant has shown that the low bias current of 120 $\mu$A in the high sensitive 11-rings sensor 4 can detect the spin-transition of 1.2.10$^{-4}$ mm$^{-3}$ spot of bistable nanoparticles without external magnetic field and any pre-amplifier. The local and precise measurement of the device allowed us to detect the low magnetic moment of 3. 10$^{-13}$ emu, which never achieved by other experimental methods at room temperature. This could represent the important step towards to the ultimate goal of single particle investigation. Moreover, after avoiding the need of external magnet and the need of pre-amplifier device, high bias current is also avoided. This can allow preventing the self-heating and the sensor breakdown due to the high current density. In this specification, the magnetic studies of nanoparticles highlighted the ability of the sensor 4 in use to separate the diamagnetic and paramagnetic susceptibilities in small quantity of bistable materials. The paramagnetic susceptibility found in this case is slightly superior to the susceptibility measured by the SQUID system. These important results are the proof of concept for miniaturization of the measurement setup device. This device also provides us an effective and inexpensive way to reach the ultra-high magnetic resolutions for different applications such as bio- and magnetic sensors or the gas sensing developed in the Applicant's group.

**Claims**

1. A measurement system (2) adapted to characterize at least one single magnetic object comprising:

    - a magnetic AMR/PHR sensor (4) comprising:

• an active surface (14) on which at least one magnetic particle (12) is deposited and including a magnetic probe (24) with a closed loop shape, the magnetic probe (24) being made in a structure chosen in the group consisting of a bi-layered structure including a ferromagnetic film and an anti-ferromagnetic film, a spin-valve structure including a ferromagnetic film, a metal, a ferromagnetic and an anti-ferromagnetic film, and a tri-layered structure including a ferromagnetic film, a metal and an anti-ferromagnetic film,
• a first terminal (32),
• a second terminal (34), both terminals facing each other and contacting with the magnetic probe (24),

- a source (6) adapted to inject an alternative current or voltage in the magnetic probe (24), the source (6) being connected between the first and second terminals (32, 34) and the current or voltage vibrating at an exciting frequency, and
- a voltage measurement device (8) connected between the first and second terminals (32, 34) measuring the differential voltage between the pair of terminals (32, 34), **characterized in that** it further comprises
- a signal acquisition device (52) adapted to extract the amplitude at twice the exciting frequency in the measured differential voltage and to deduce at least one physical quantity of the at least one magnetic particle (12) based on the extracted amplitude.

2. The measurement system according to claim 1, wherein the measurement system (2) is deprived of coils adapted to produce an external magnetic field on the sensor (4).

3. The measurement system according to claim 1 or 2, wherein the measurement system (2) is deprived of preamplifier adapted to amplify the differential voltage

4. The measurement system according to any one of claims 1 to 3, wherein the magnetic probe (24) has a ring shape.

5. The measurement system according to any one of claims 1 to 3, wherein the magnetic probe (24) has a multi-ring shape.

6. The measurement system according to claim 5, wherein the number of rings is comprised between 1 and 17.

7. The measurement system according to any one of claims 1 to 6, wherein the signal acquisition device (52) comprises a processor (22) and a lock-in unit (46).

8. The measurement system according to any one of claims 1 to 6, wherein the first terminal is a voltage terminal, the second terminal is a voltage terminal, the magnetic probe (24) further comprising:

- a first current/voltage terminal (28) and
- a second current terminal/voltage (30), the first and second current/voltage terminals (28, 30) forming a pair of current/voltage terminals which face each other contacting with the magnetic probe (24),
- a first arm (102) made of a first set of a predetermined ring number lower than 18 of circular meander paths (104) delimited within a first quarter surface (106) of the first magnetic sensor (4), the outermost meander path (108) being connected to the first current/voltage terminal (28) and the innermost meander path (110) being connected to the first voltage terminal (32),
- a second arm (112) made of a second set of the same predetermined number of circular meander paths (114) delimited within a second quarter surface (116) of the first magnetic sensor (4), the outermost meander path (118) being connected to the second current/voltage terminal (30) and the innermost meander path (120) being connected to the first voltage terminal (32),
- a third arm (122) made of a third set of the same ring number of circular meander paths (124) delimited within a third quarter surface (126) of the first magnetic sensor (4), the outermost meander path (128) being connected to the second current/voltage terminal (30) and the innermost meander path (130) being connected to the second voltage terminal (34), and
- a fourth arm (132) made of a fourth set of the same ring number of circular meander paths (134) delimited within a fourth quarter surface (136) of the first magnetic sensor (4), the outermost meander path (138) being connected to the first current/voltage terminal (30) and the innermost meander path (140) being connected to the second voltage terminal (34).

9. The measurement system according to any one of claims 1 to 8, wherein the physical quantity is relative to the at least one magnetic particle (12).

**10.** The measurement system according to any one of claims 1 to 9, wherein the exciting frequency is at least 1 Hz.

**11.** The measurement system according to any one of claims 1 to 10, wherein several magnetic particles (12) forming a diamagnetic and paramagnetic mixture are deposited on the active surface (14) and the physical quantity is the diamagnetic susceptibility of the mixture or the paramagnetic susceptibility of the mixture.

**12.** A measuring method comprising the steps of:

- providing a measurement system (2) adapted to detect the presence of at least one single magnetic object comprising a magnetic AMR/PHR sensor (4) comprising:

◦ an active surface (14) on which at least one magnetic particle (12) is deposited and including a magnetic probe (24) with a closed loop shape, the magnetic probe (24) being made in a structure chosen in the group consisting of a bi-layered structure including a ferromagnetic film and an anti-ferromagnetic films, a spin-valve structure including a ferromagnetic film, a metal, a ferromagnetic and an anti-ferromagnetic film, and a tri-layered structure including a ferromagnetic film, a metal and an anti-ferromagnetic film,
◦ a first terminal (32),
◦ a second terminal (34), both terminals facing each other and contacting with the magnetic probe (24),

- injecting an alternative current or voltage in the magnetic probe (24), the current or voltage vibrating at an exciting frequency by using a source connected between the first and second terminals (32, 34),
- measuring the differential voltage between the pair of voltage terminals by using a voltage measurement device (8) connected between the first and second terminals (32, 34), **characterized in that** it further comprises the steps of
- extracting the amplitude at twice the exciting frequency in the differential voltage by using a signal acquisition device (52), and
- deducing at least one physical quantity of the at least one magnetic particle (12) based on the extracted amplitude.

**13.** The measuring method according to claim 12, wherein several magnetic particles (12) forming a mixture are deposited on the active surface (14) and the step of deducing comprises the sub-steps of:

- obtaining a total susceptibility of the mixture,
- extracting the diamagnetic susceptibility of the mixture, and
- obtaining the paramagnetic susceptibility of the mixture by using the total susceptibility of the mixture and the diamagnetic susceptibility of the mixture.

**Patentansprüche**

**1.** Messsystem (2), ausgelegt zum Charakterisieren mindestens eines einzelnen magnetischen Objekts, das Folgendes umfasst:

- einen magnetischen AMR/PHR-Sensor (4), der Folgendes umfasst:

• eine aktive Oberfläche (14), auf der mindestens ein magnetisches Partikel (12) abgesetzt ist und die eine magnetische Sonde (24) in Form einer geschlossenen Schleife enthält, wobei die magnetische Sonde (24) in einer Struktur ausgeführt ist, die ausgewählt ist aus der Gruppe bestehend aus einer zweischichtigen Struktur mit einem ferromagnetischen Film und einem anti-ferromagnetischen Film, einer Spin-Ventil-Struktur mit einem ferromagnetischen Film, einem Metall, einem ferromagnetischen und einem anti-ferromagnetischen Film, und einer dreischichtigen Struktur mit einem ferromagnetischen Film, einem Metall und einem anti-ferromagnetischen Film,
• einen ersten Anschluss (32),
• einen zweiten Anschluss (34), wobei beide Anschlüsse einander zugewandt sind und mit der magnetischen Sonde (24) in Kontakt stehen,

- eine Quelle (6), ausgelegt zum Speisen eines Wechselstroms oder einer Wechselspannung in die magnetische Sonde (24), wobei die Quelle (6) zwischen den ersten und zweiten Anschluss (32, 34) geschaltet ist und der Strom oder die Spannung mit einer Anregungsfrequenz schwingt, und

- ein Spannungsmessgerät (8), das zwischen den ersten und zweiten Anschluss (32, 34) geschaltet ist und die Differenzspannung zwischen dem Paar Anschlüssen (32, 34) misst, **dadurch gekennzeichnet, dass** es ferner Folgendes umfasst:

- ein Signalerfassungsgerät (52), ausgelegt zum Extrahieren der Amplitude beim Zweifachen der Anregungsfrequenz in der gemessenen Differenzspannung und zum Ableiten mindestens einer physikalischen Größe des mindestens einen magnetischen Partikels (12) auf der Basis der extrahierten Amplitude.

2.  Messsystem nach Anspruch 1, wobei das Messsystem (2) keine zum Erzeugen eines externen Magnetfelds auf dem Sensor (4) ausgelegten Spulen aufweist.

3.  Messsystem nach Anspruch 1 oder 2, wobei das Messsystem (2) keinen zum Verstärken der Differenzspannung ausgelegten Vorverstärker aufweist.

4.  Messsystem nach einem der Ansprüche 1 bis 3, wobei die magnetische Sonde (24) eine Ringform aufweist.

5.  Messsystem nach einem der Ansprüche 1 bis 3, wobei die magnetische Sonde (24) eine Mehrringform aufweist.

6.  Messsystem nach Anspruch 5, wobei die Anzahl der Ringe zwischen 1 und 17 liegt.

7.  Messsystem nach einem der Ansprüche 1 bis 6, wobei das Signalerfassungsgerät (52) einen Prozessor (22) und eine Lock-In-Einheit (46) umfasst.

8.  Messsystem nach einem der Ansprüche 1 bis 6, wobei der erste Anschluss ein Spannungsanschluss ist, der zweite Anschluss ein Spannungsanschluss ist, wobei die magnetische Sonde (24) ferner Folgendes umfasst:

    - einen ersten Strom-/Spannungsanschluss (28) und

    - einen zweiten Strom-/Spannungsanschluss (30), wobei der erste und zweite Strom-/Spannungsanschluss (28, 30) ein Paar Strom-/Spannungsanschlüsse bilden, die einander zugewandt sind und mit der magnetischen Sonde (24) in Kontakt stehen,

    - einen ersten Zweig (102), welcher aus einem ersten Satz von einer vorbestimmten Ringanzahl kleiner als 18 von ringförmigen Mäanderpfaden (104) gemacht ist, der innerhalb einer ersten Viertelfläche (106) des ersten magnetischen Sensors (4) begrenzt ist, wobei der äußerste Mäanderpfad (108) mit dem ersten Strom-/Spannungsanschluss (28) verbunden ist und der innerste Mäanderpfad (110) mit dem ersten Spannungsanschluss (32) verbunden ist,

    - einen zweiten Zweig (112), welcher aus einem zweiten Satz der gleichen vorbestimmten Anzahl von ringförmigen Mäanderpfaden (114) gemacht ist, der innerhalb einer zweiten Viertelfläche (116) des ersten Magnetsensors (4) begrenzt ist, wobei der äußerste Mäanderpfad (118) mit dem zweiten Strom-/Spannungsanschluss (30) verbunden ist und der innerste Mäanderpfad (120) mit dem ersten Spannungsanschluss (32) verbunden ist,

    - einen dritten Zweig (122), welcher aus einem dritten Satz der gleichen Ringanzahl von ringförmigen Mäanderpfaden (124), der innerhalb einer dritten Viertelfläche (126) des ersten Magnetsensors (4) begrenzt ist, wobei der äußerste Mäanderpfad (128) mit dem zweiten Strom-/Spannungsanschluss (30) verbunden ist und der innerste Mäanderpfad (130) mit dem zweiten Spannungsanschluss (34) verbunden ist, und

    - einen vierten Zweig (132), welcher aus einem vierten Satz der gleichen Ringanzahl von ringförmigen Mäanderpfaden (134) gemacht ist, der innerhalb einer vierten Viertelfläche (136) des ersten magnetischen Sensors (4) begrenzt ist, wobei der äußerste Mäanderpfad (138) mit dem ersten Strom-/Spannungsanschluss (30) verbunden ist und der innerste Mäanderpfad (140) mit dem zweiten Spannungsanschluss (34) verbunden ist.

9.  Messsystem nach einem der Ansprüche 1 bis 8, wobei sich die physikalische Größe auf das mindestens eine magnetische Partikel (12) bezieht.

10. Messsystem nach einem der Ansprüche 1 bis 9, wobei die Anregungsfrequenz mindestens 1 Hz beträgt.

11. Messsystem nach einem der Ansprüche 1 bis 10, wobei mehrere magnetische Partikel (12), die ein diamagnetisches und paramagnetisches Gemisch bilden, auf der aktiven Oberfläche (14) abgesetzt sind und die physikalische Größe die diamagnetische Suszeptibilität des Gemisches oder die paramagnetische Suszeptibilität des Gemischs ist.

12. Messverfahren, das die folgenden Schritte beinhaltet:

- Bereitstellen eines Messsystems (2), ausgelegt zum Detektieren der Anwesenheit mindestens eines einzelnen magnetischen Objekts, das einen magnetischen AMR/PHR-Sensor (4) umfasst, das Folgendes beinhaltet:

  ◦ eine aktive Oberfläche (14), auf der mindestens ein magnetisches Partikel (12) abgesetzt ist und die eine magnetische Sonde (24) mit einer geschlossenen Schleifenform enthält, wobei die magnetische Sonde (24) ausgeführt ist in einer Struktur, die ausgewählt ist aus der Gruppe bestehend aus einer zweischichtigen Struktur mit einem ferromagnetischen Film und einem anti-ferromagnetischen Film, einer Spin-Valve-Struktur mit einem ferromagnetischen Film, einem Metall, einem ferromagnetischen und einem anti-ferromagnetischen Film, und einer dreischichtigen Struktur mit einem ferromagnetischen Film, einem Metall und einem anti-ferromagnetischen Film,
  ◦ einen ersten Anschluss (32),
  ◦ einen zweiten Anschluss (34), wobei beide Anschlüsse einander zugewandt sind und mit der magnetischen Sonde (24) in Kontakt stehen,

- Speisen eines Wechselstroms oder einer Wechselspannung in die magnetische Sonde (24), wobei der Strom oder die Spannung mit einer Anregungsfrequenz schwingt, indem eine Quelle verwendet wird, die zwischen den ersten und zweiten Anschluss (32, 34) geschaltet ist,
- Messen der Differenzspannung zwischen dem Paar Spannungsanschlüssen mit einem Spannungsmessgerät (8), das zwischen den ersten und zweiten Anschluss (32, 34) geschaltet ist, **dadurch gekennzeichnet, dass** es ferner die folgenden Schritte beinhaltet:
- Extrahieren der Amplitude beim Zweifachen der Anregungsfrequenz in der Differenzspannung mit einem Signalerfassungsgerät (52), und
- Ableiten mindestens einer physikalischen Größe des mindestens einen magnetischen Partikels (12) auf der Basis der extrahierten Amplitude.

13. Messverfahren nach Anspruch 12, wobei mehrere magnetische Partikel (12), die ein Gemisch bilden, auf der aktiven Oberfläche (14) abgesetzt werden und der Schritt des Ableitens die folgenden Teilschritte beinhaltet:

  - Ermitteln einer Gesamtsuszeptibilität des Gemischs,
  - Extrahieren der diamagnetischen Suszeptibilität des Gemischs, und
  - Gewinnen der paramagnetischen Suszeptibilität des Gemischs anhand der Gesamtsuszeptibilität des Gemischs und der diamagnetischen Suszeptibilität des Gemischs.


**Revendications**

1. Système de mesure (2) adapté pour caractériser au moins un objet magnétique unique comprenant:

  - un capteur magnétique AMR/PHR (4) comprenant:

    • une surface active (14) sur laquelle au moins une particule magnétique (12) est déposée et incluant une sonde magnétique (24) ayant une forme de boucle fermée, la sonde magnétique (24) constituée selon une structure choisie parmi le groupe formé d'une structure à deux couches incluant un film ferromagnétique et un film antiferromagnétique, une structure de vanne de spin incluant un film ferromagnétique, un métal, un film ferromagnétique et antiferromagnétique, et une structure à trois couches incluant un film ferromagnétique, un métal et un film antiferromagnétique,
    • une première borne (32),
    • une seconde borne (34), les deux bornes se faisant face l'une à l'autre et entrant en contact avec la sonde magnétique (24),

  - une source (6) adaptée pour injecter un courant ou une tension alternatif/- ve dans la sonde magnétique (24), la source (6) étant connectée entre la première et la seconde borne (32, 34) et le courant ou la tension vibrant à une fréquence d'excitation, et
  - un dispositif de mesure de tension (8) connecté entre la première et la seconde borne (32, 34) mesurant la tension différentielle entre la paire de bornes (32, 34), **caractérisé en ce qu'**il comprend en outre
  - un dispositif d'acquisition de signal (52) adapté pour extraire l'amplitude à deux fois la fréquence d'excitation dans la tension différentielle mesurée et pour déduire au moins une quantité physique de l'au moins une particule magnétique (12) sur la base de l'amplitude extraite.

**2.** Système de mesure selon la revendication 1, dans lequel le système de mesure (2) est dépourvu de bobines adaptées pour produire un champ magnétique externe sur le capteur (4).

**3.** Système de mesure selon la revendication 1 ou 2, dans lequel le système de mesure (2) est dépourvu d'un préamplificateur adapté pour amplifier la tension différentielle.

**4.** Système de mesure selon l'une quelconque des revendications 1 à 3, dans lequel la sonde magnétique (24) a une forme de boucle.

**5.** Système de mesure selon l'une quelconque des revendications 1 à 3, dans lequel la sonde magnétique (24) a une forme à boucles multiples.

**6.** Système de mesure selon la revendication 5, dans lequel le nombre de boucles est compris entre 1 et 17.

**7.** Système de mesure selon l'une quelconque des revendications 1 à 6, dans lequel le dispositif d'acquisition de signal (52) comprend un processeur (22) et une unité de verrouillage (46).

**8.** Système de mesure selon l'une quelconque des revendications 1 à 6, dans lequel la première borne est une borne de tension, la seconde borne est une borne de tension, la sonde magnétique (24) comprenant en outre:

- une première borne de courant/tension (28) et
- une seconde borne de courant/tension (30), la première et la seconde borne de courant/tension (28, 30) formant une paire de bornes de courant/tension qui se font face l'une à l'autre et entrant en contact avec la sonde magnétique (24),
- un premier bras (102) fait d'un premier ensemble d'un nombre de boucles prédéterminé, inférieur à 18, de voies en méandres circulaires (104), délimité dans un premier quart de surface (106) du premier capteur magnétique (4), la voie en méandres la plus à l'extérieur (108) étant connectée à la première borne de courant/tension (28) et la voie en méandres la plus à l'intérieur (110) étant connectée à la première borne de tension (32),
- un second bras (112) fait d'un second ensemble du même nombre prédéterminé de voies en méandres circulaires (114), délimité dans un second quart de surface (116) du premier capteur magnétique (4), la voie en méandres la plus à l'extérieur (118) étant connectée à la seconde borne de courant/tension (30) et la voie en méandres la plus à l'intérieur (120) étant connectée à la première borne de tension (32),
- un troisième bras (122) fait d'un troisième ensemble du même nombre de bagues de voies en méandres circulaires (124), délimité dans un troisième quart de surface (126) du premier capteur magnétique (4), la voie en méandres la plus à l'extérieur (128) étant connectée à la seconde borne de courant/tension (30) et la voie en méandres la plus à l'intérieur (130) étant connectée à la seconde borne de tension (34), et
- un quatrième bras (132) fait d'un quatrième ensemble du même nombre de bagues de voies en méandres circulaires (134), délimité dans un quatrième quart de surface (136) du premier capteur magnétique (4), la voie en méandres la plus à l'extérieur (138) étant connectée à la première borne de courant/tension (30) et la voie en méandres la plus à l'intérieur (140) étant connectée à la seconde borne de tension (34).

**9.** Système de mesure selon l'une quelconque des revendications 1 à 8, dans lequel la quantité physique est liée à l'au moins une particule magnétique (12).

**10.** Système de mesure selon l'une quelconque des revendications 1 à 9, dans lequel la fréquence d'excitation est d'au moins 1 Hz.

**11.** Système de mesure selon l'une quelconque des revendications 1 à 10, dans lequel plusieurs particules magnétiques (12) formant un mélange diamagnétique et paramagnétique sont déposées sur la surface active (14) et la quantité physique est la susceptibilité diamagnétique du mélange ou la susceptibilité paramagnétique du mélange.

**12.** Procédé de mesure comprenant les étapes de:

- fourniture d'un système de mesure (2) adapté pour détecter la présence d'au moins un objet magnétique unique comprenant un capteur magnétique AMR/PHR (4) comprenant:

  ∘ une surface active (14) sur laquelle au moins une particule magnétique (12) est déposée et incluant une sonde magnétique (24) ayant une forme de boucle fermée, la sonde magnétique (24) étant faite d'une structure choisie parmi le groupe formé d'une structure à deux couches incluant un film ferromagnétique et un film antiferromagnétique, une structure de vanne de spin incluant un film ferromagnétique, un métal, un film ferromagnétique et antiferromagnétique, et une structure à trois couches incluant un film ferromagnétique, un métal et un film antiferromagnétique,

   ◦ une première borne (32),
   ◦ une seconde borne (34), les deux bornes faisant face l'une à l'autre et entrant en contact avec la sonde magnétique (24),

- d'injection d'un courant ou d'une tension alternatif/-ve dans la sonde magnétique (24), le courant ou la tension vibrant à une fréquence d'excitation en utilisant une source connectée entre la première et la seconde borne (32, 34),
- mesure de la tension différentielle entre la paire de bornes de tension en utilisant un dispositif de mesure de tension (8) connecté entre la première et la seconde borne (32, 34), **caractérisé en ce qu'**il comprend en outre les étapes de
- extraction de l'amplitude à deux fois la fréquence d'excitation dans la tension différentielle en utilisant un dispositif d'acquisition de signal (52), et
- déduction d'au moins une quantité physique de l'au moins une particule magnétique (12) sur la base de l'amplitude extraite.

**13.** Procédé de mesure selon la revendication 12, dans lequel plusieurs particules magnétiques (12) formant un mélange sont déposées sur la surface active (14) et l'étape de déduction comprend les sous-étapes:

- d'obtention d'une susceptibilité totale du mélange,
- d'extraction de la susceptibilité diamagnétique du mélange, et
- d'obtention de la susceptibilité paramagnétique du mélange en utilisant la susceptibilité totale du mélange et la susceptibilité diamagnétique du mélange.

EP 3 208 627 B1

**FIG.1**

**FIG.2**

21

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2685273 A1